# EUROPEAN PATENT SPECIFICATION

(11) **EP 2 584 749 B1**
(45) Date of publication and mention of the grant of the patent: **10.09.2014**
(21) Application number: 11290482.6
(22) Date of filing: 19.10.2011
(51) Int. Cl.: H04L 27/00, H04L 27/04, H04L 27/06, H04L 27/20, H04L 27/36

(54) **Radio communication system, home gateway, bidirectional communication system, and method for stabilising a sideband signal**
Funkkommunikationssystem, Heim-Gateway, bidirektionales Kommunikationssystem und Verfahren zur Stabilisierung eines Seitenbandsignals
Système de communication radio, passerelle d'accueil, système de communication bidirectionnel et procédé pour stabiliser un signal à bandes latérales

(43) Date of publication of application: 24.04.2013
(73) Proprietor: Karlsruher Institut Für Technologie (KIT), 76131 Karlsruhe (DE); Institut Polytechnique de Grenoble, 38031 Grenoble Cedex (FR)
(72) Inventor: Zwick, Thomas, 76676 Graben-Neudorf (DE); Brendel, Friederike, 38000 Grenoble (FR); Poette, Julien, 38220 Vizille (FR); Cabon, Béatrice, 38410 Saint-Martin D'Uriage (FR)
(74) Representative: Müller-Boré & Partner Patentanwälte PartG mbB

(56) References cited:
- WO-A1-2010/094171
- US-A- 4 060 773
- US-A- 5 940 457
- US-A1- 2006 220 750
- US-B1- 6 255 912
- "PHASE-LOCKED LOOP", IBM TECHNICAL DISCLOSURE BULLETIN, INTERNATIONAL BUSINESS MACHINES CORP. (THORNWOOD), US, vol. 32, no. 6B, 1 November 1989 (1989-11-01), page 465/466, XP000073847, ISSN: 0018-8689

## Description

The invention relates to a radio communication system, a home gateway, a bidirectional communication system, and a method for stabilising a sideband signal.

In the transmitter of a radio communication system, an information carrying digital sideband signal is modulated to an analogue sub-carrier signal. It is subsequently up-converted by being mixed with a radio frequency (RF) carrier in a dedicated frequency band corresponding to the target application. Through a basic mixing process, two sidebands are created around a spectral component corresponding to a carrier signal, one of which will be selected and transmitted by an antenna.

A stable operation of the radio system can only be assured if the users can synchronise their receiver equipment with the central frequency of the transmitted sideband. The stability of this sideband is therefore essential for the overall function of the system. In conventional radio systems, certain measures are usually undertaken to stabilise the RF carrier, thus obtaining a stable sideband through the mixing process. That is why in conventional systems, the output frequency of a voltage controlled local oscillator (VC(L)O) serving as RF source is usually stabilised by using a phase locked loop (PLL) before up-converting the sub-carrier signal.

By means of the phase locked loop a carrier phase noise can be reduced considerably. This method can always be applied as long as the local oscillator frequency is generated in such a way that it can be influenced by an electrical quantity, e.g. by a DC control voltage, so that small deviations from the nominal value can be compensated for by the phase locked loop. This is the case when conventional voltage controlled oscillators (VCO) are used as local oscillators (LO).

The phase locked loop concept allows for the stabilisation of the single tone signal, such as the one at the output of a voltage controlled oscillator. It does not allow for the stabilisation of a signal that consists of several frequencies, like a modulated sideband signal.

Techniques for the optical generation and transmission of RF signals in the millimetre wave-range are currently being investigated. These techniques represent a low cost alternative to electrical RF oscillators in future broad band communication systems in the 60 GHz range, for example for high data-rate home networks. They allow the nearly loss-free transmission of a millimetre wave signal over optical fibre networks to an antenna access point. In case of optical generation of the RF signal, the modulation and mixing process will be realised in the optical domain using intensity modulation (IM) as result of an electro-optical conversion and optical mixing. After a transmission of the optical signal across a fibre, the signal is detected by a suitable photodetector and converted back to an electrical signal (opto-electrical conversion). The RF carrier signal can be generated by interference (beating) of two monochromatic optical fields with a constant phase relation. In the photodetector, the interference results in an electrical current signal at an RF beat frequency corresponding to the separation in wavelength of the optical fields, thus providing an electrical RF carrier signal. Classic optical modulation methods are e.g. a direct modulation of the laser bias current or external modulation in dedicated modulators, e.g. lithium-niobate modulators.

Thus, the stability of the RF carrier signal depends directly on the stability of the beat signal of the optical signals. Depending on the type of optical RF generation, this stability might not be influenceable in the same way as the voltage controlled oscillator that was described above. In the case that the beat signal shows an increased noise, this noise will also appear in the electrical signal derived therefrom. In the up-conversion process, this instability will be reproduced and be present in the sidebands. If such a sideband is then transmitted across a radio link, a synchronisation of the radio receiver will be hindered or even made impossible.

In conventional analogue optical communication systems, optical or hybrid phase locked loops have already been proposed for the stabilisation of a monochromatic optical signal. These loops are based on the same principle as the conventional phase locked loop and have been, where necessary, completed by additional opto-electrical components. An electrical quantity or another accessible physical quantity serves as control variable for fine tuning of the optical oscillator as carrier oscillator. Consequently, the phase locked loop architecture has to be adapted according to the type of electro-optical converter, e.g. different laser architectures, or laser and modulator.

Document WO 2010/094171 relates to a method and apparatus for generating a carrier frequency signal. The method includes generating a first frequency signal; injecting a modulation signal at a first point of the two-point modulation architecture; generating a second frequency signal from the modulation signal; introducing the second frequency signal by mixing the first frequency signal and the second frequency signal to generate a mixed frequency signal and outputting the carrier frequency signal selected from the mixed frequency signal.

Document US 4,060,773 relates to a frequency modulation system. An output frequency of a first variable frequency oscillator is frequency-divided and the frequency divided signal is compared in phase with the output frequency of a reference frequency oscillator. The result of the phase comparing is fed back to the first variable frequency oscillator for controlling the output frequency of the first variable frequency oscillator. The output frequency of a second variable frequency oscillator is mixed with the output frequency of a fixed frequency oscillator to produce a difference frequency between both output frequencies. The difference frequency is compared in phase with the output frequency of the first variable frequency oscillator. The result of the phase comparing is used for controlling the output frequency of the second variable frequency oscillator. The output frequency of the fixed frequency oscillator is frequency-modulated by the frequency of a modulating signal.

Document "Phase Locked-Loop", IBM Technical disclosure bulletin, international business machines corp. (Thornwood), US, vol. 32, no. 6B relates to a method of frequency modulating a phase-locked loop and building a frequency agile FM or frequency shift keying transmitter.

Document US 2006/0220750 relates to a PLL circuit equipped with a loop gain detecting circuit that can suppress the change of the loop gain. When detecting the loop gain, the frequency of the input signal to the second input of the phase detector is first changed, and the response corresponding to the change is detected by the output of the voltage locked oscillator. The detection is performed by connecting the output of the voltage locked oscillator with the counter and connecting the output of the counter with the integrator. The phase locked loop characteristics are optimized by performing feedback for the detection result on the value of the charge pump current.

Document US 6,255,912 relates to a phase lock loop used as up converter and for reducing phase noise of an output signal. A modulated signal is translated to a broadcast frequency by a translation phase lock loop. In the translation phase lock loop the output frequency, which is the broadcast frequency, is mixed with a translation frequency, and the resulting translated frequency is compared to the modulated signal. If an amplitude modulator is inserted into the translation loop, the phase comparison/feedback nature of the phase lock loop will tend to cancel the phase noise introduced in the amplitude modulation process. Any other circuits placed within the loop will tend to have any phase noise they introduce, which is in the phase lock loop bandwidth, canceled by the loop.

Document US 5,940,457 relates to millimeter-wave (MMW) synthesizer with FSK modulation transmitter. The synthesizer is implemented as a frequency-shift-keyed PLL frequency synthesizer with large frequency-multiplication factor, with absolute frequency deviation independent of frequency-multiplication factor. The PLL also has fractional frequency-multiplication-factor programming capability. The PLL lacks the need to compensate modulator frequency deviation with possible resulting stabilization-time requirements, associated with each PLL output-frequency change.

Certain laser architectures allow for active mode locking of the optical modes. In this case, the modes can be stabilised by applying an electrical radio frequency signal of the same frequency as the desired carrier to the laser. The use of electrical radio frequency carriers is an expensive way to provide a stabilised sideband signal.

Furthermore, optical feedback loops have been proposed, where a part of the laser light is reinjected into the cavity in a controlled manner. However, the set up is relatively complex, as the phase difference caused by the feed back loop has to be chosen exactly so as to match the optical phases of the signals leaving and reentering the cavity.

In the most disadvantageous case, the phase of the optical signal cannot be fine tuned by an electrical signal. This might occur when the laser phase noise depends predominantly on its physical structure instead of on its bias circuitry, or when other optical components with increased noise contribution (e.g. optical amplifiers) are present in the optical subsystem.

It is an object of the invention to provide improved means for generating a stabilised sideband signal.

This object is achieved by the subject matter of the independent claims.

According to an aspect, a radio communication system comprises a carrier oscillator that is configured to generate a carrier signal at a carrier frequency, a sub-carrier oscillator configured to generate a sub-carrier signal at a sub-carrier frequency, and a phase error detection means configured to generate an error indicator, in particular an error voltage, corresponding to a phase error of the carrier signal and/or the sub-carrier signal. The sub-carrier oscillator is implemented as a controlled oscillator, in particular a voltage controlled oscillator (VCO), being controlled by the error indicator of the phase error detection means. The phase error detection means is detecting the phase error of the carrier oscillator and/or the phase error of a mixed signal comprising mixing products of the carrier oscillator and the sub-carrier oscillator. The phase error can be caused by noise of the carrier oscillator and/or by noise of the sub-carrier oscillator. The detected phase error is not used to control the phase of the carrier oscillator as in conventional systems, but of the sub-carrier oscillator. Since the signal to be transmitted is a mixing product of the signal of the carrier oscillator and the sub-carrier oscillator, controlling the sub-carrier oscillator by variation of its DC control voltage and/or current derived from the detected phase error results in a stabilisation of the mixing product itself.

One important signal to be generated by the radio communication system is a double sideband signal which consists of a carrier signal, e.g. in the millimetre wave range around 60 GHz, and of an upper and lower sideband of well defined bandwidth, representing the information to be transmitted. The double sideband signal is obtained by mixing the high frequency carrier signal with an information-carrying sub-carrier signal previously modulated by an information-carrying baseband signal.

Thus, the sideband signals correspond to the mixing products and are centred at the frequency sum and frequency difference of the carrier frequency and the sub-carrier frequency. After one mixing product, meaning one of the sideband signals, has been chosen for transmission, an error indicator corresponding to the detected phase error is added to or subtracted from the control voltage and/or current of the sub-carrier oscillator in order to generate the stabilised sideband signal such that the centre frequencies of the two sidebands correspond to their nominal values.

A mixing signal resulting from the mixing of two or more signals ear comprise multiple spectral components referred to as mixing products at multiple frequencies, in particular at the sum and the difference of the frequencies of the original signals. The mixing product can further comprise parts of the original signals at their original frequencies.

In such a radio communication system a carrier oscillator can be used that does not need to be voltage controlled, since its phase error and noise is compensated for by the voltage controlled sub-carrier oscillator.

The sub-carrier oscillator is thus controlled by the phase error detection means, such that at least one of the mixing products of the carrier signaland the sub-carrier signal is stabilised through a reduction of the over-all phase error.

The error indicator corresponding to the phase error means that the error indicator is a function of the detected phase error. The error indicator can e.g., be the control voltage for the sub-carrier oscillator enhanced by a voltage corresponding to the phase error, or it can e.g., be a voltage containing only the phase error that is added to or subtracted from the regular control voltage of the sub-carrier oscillator to compensate for the phase error of the carrier oscillator.

A mixing process does not substantially change the phase noise characteristics of the signals to be mixed. Therefore, the instability of the carrier oscillator is transferred to another frequency range.

Thus, an all electrical compensation of the phase error is provided, even if the carrier oscillator is implemented as an optical oscillator, such as a laser.

The sub-carrier oscillator being implemented as a controlled oscillator means that its oscillating frequency can be adjusted according to one or more electrical parameters such as its drive voltage and/or drive current.

A radio communication system is a system, in particular an analogue system, for generating a radio signal, in particular a sideband signal, in any electromagnetic or electric form.

In one embodiment of the invention, the radio communication system comprises mixing means configured to generate a mixed signal comprising the carrier signal, the phase error, and the mixing products of the carrier signal and the sub-carrier signal. In this embodiment, the phase error detection means is configured to generate the error indicator from the mixed signal. The phase error of the sub-carrier oscillator is usually considerably lower than the phase error of the carrier oscillator. Therefore, the main detected phase error will be the phase error of the carrier oscillator. However, by including the phase error of the sub-carrier into the error indicator, at least one of the mixing products of the carrier signal and the sub-carrier signal is stabilised. Calculating the phase error from the mixed signal also comprises an assembly advantage that will become apparent below when the embodiments are discussed. The mixed signal from which the phase error is detected is implemented as a single tone signal. That means that it is implemented free of information modulation.

In this embodiment, the radio communication system comprises a pre-mixing means configured to generate a pre-mixed signal consisting of the carrier signal, the phase error, and the mixing products of the carrier and the sub-carrier signals. A band pass filter is arranged to filter or extract the carrier signal out of the pre-mixed signal. This pre-mixed signal already comprises the sub-carrier signal, the sub-carrier signal comprising an information signal modulated therewith. Thus, extracting the carrier signal from this pre-mixed signal eliminates other spectral components induced by the mixing of the carrier signal with the information modulated sub-carrier signal from the resulting radio spectrum. Therein, the mixing means is arranged to generate the mixed signal using the carrier signal that is extracted from the pre-mixed signal. Thus, the mixing means generates a single tone mixed signal, from which the phase error is detected by the phase error detection means.

The spectral components of the mixed signal appear at frequencies that correspond to combinations of the carrier frequency, the sub-carrier frequency, and the time derivative of the phase error.

The spectral components of the pre-mixed signal appear at frequencies that correspond to combinations of the carrier frequency, the sub-carrier frequency and all frequencies within the spectrum resulting from an information signal modulated thereto, and the time derivative of the phase error.

In one embodiment, the phase error detection means is implemented as a phase locked loop (PLL). The working principle of a phase locked loop is known to a person skilled in the art. Summarising, a phase locked loop generates an error indicator that corresponds, e.g. is proportional, to a phase error that is detected by comparing the frequency of a signal to be checked with a reference signal. The error indicator is a function of the phase error. The generated error indicator is used to control the sub-carrier oscillator so that the phase error in the up-converted mixed signal is minimised or eliminated.

The radio communication system comprises a modulator that is arranged to modulate an information signal to the sub-carrier signal. The sub-carrier oscillator thus provides a sub-carrier signal to the modulator that modulates the information signal to it, and e.g., by means of a second output, the sub-carrier oscillator also provide its unmodulated signal to the mixing means that mixes the unmodulated sub-carrier signal with the carrier signal of the carrier oscillator. The information signal can comprise a time dependent inphase and quadrature component (I(t) and Q(t)). The radio communication system can be used to transmit information in a stabilised sideband.

In one embodiment, the carrier oscillator is implemented as an optical oscillator, e.g. as a laser. The frequency of most lasers cannot be modulated by changing a voltage. Therefore, sufficiently stable lasers are not used in conventional radio communication systems as described in the background of the invention. By stabilising the sub-carrier oscillators with the phase error of the carrier oscillator, lasers can be used as carrier oscillators even though the laser itself is not a voltage controlled oscillator and without the need of optical/hybrid phase locked loops. Generally speaking, the radio communication system is independent of the type of optical generation used.

In one embodiment, the radio communication system comprises a transmitter to transmit a modulated sideband signal comprising the sub-carrier signal controlled by the error indicator of the phase error detection means. The transmitter can, for example, be an antenna to launch the signal into a wireless channel when the signal shall be transmitted as an electromagnetic wave, or a device to launch the signal into an optical fibre when the signal shall be transmitted as an optical wave. Alternatively, the signal can also be transmitted by a conventional wire connection as an electrical signal.

The carrier oscillator can be implemented as a millimetre-wave(mmw-) oscillator, e.g. in the 60 GHz range. The sub-carrier frequency is usually considerably lower than the carrier frequency. Typical sub-carrier frequencies have a nominal value of about 1 % to 20% of the carrier frequency.

In one embodiment, the carrier oscillator is implemented as a free-running oscillator comprising a fixed control voltage. In other words, the carrier oscillator is not implemented as a voltage controlled oscillator of which the frequency can be influenced by regulating its control voltage/current.

In one embodiment, the radio communication system comprises a band pass filter arranged to filter a predetermined mixing product from the spectrum of the mixed signal comprising the carrier signal and multiple mixing products of the carrier and the sub-carrier signals. This predetermined mixing product is selected to get stabilised and to transmit an information signal. The predetermined mixing product can, e.g. be a sideband signal at the frequency sum of the carrier frequency and the sub-carrier frequency. The predetermined signal can, e.g. be the signal at the frequency difference of the carrier frequency and the sub-carrier frequency. The band pass filter is thus used to extract the predetermined mixing product as selected spectral component further used by the radio communication system. The predetermined mixing product may also comprise the phase error.

In one embodiment, the radio communication system comprises a reference oscillator arranged to provide a reference frequency to the phase error detection means. The reference oscillator can provide a fixed frequency, with which the frequency of the predetermined mixing product is compared to detect the phase error. The reference oscillator can, for example, be a quartz oscillator.

The sub-carrier oscillator can be configured to oscillate at a sub-carrier frequency being substantially lower than the carrier frequency of the carrier oscillator. The sub-carrier frequency has a value of 1% to 20% of the carrier frequency, in particular, 5% to 10% of the carrier frequency.

An aspect of the invention relates to a home gateway comprising a radio communication system as described above. The home gateway further comprises a demodulator adapted to demodulate an external bandpass signal using the sub-carrier signal provided by the sub-carrier oscillator of the radio communication system. The external bandpass signal may be provided by an uplink. In particular, the external bandpass signal may comprise a phase error of the carrier oscillator of the radio communication system. The external bandpass signal may be demodulated by a demodulator into a baseband signal. Thus, by using the sub-carrier signal provided by the sub-carrier oscillator of the radio communication system, the phase error of the carrier oscillator may be reduced or even eliminated in the baseband signal.

An aspect of the invention relates to a bidirectional communication system comprising a home gateway as described above. The bidirectional communication system comprises a base station, wherein a downlink is adapted to transmit a signal from the radio communication system to the base station. An uplink is adapted to transmit the external bandpass signal from the base station to the demodulator. In particular, the signal to be transfered to the base station via the downlink may be the pre-mixed signal as described above. Furthermore, the base station may be adapted to extract the carrier signal from the signal received via the downlink and use this extracted carrier signal as local oscillator signal for converting an external signal down to the external bandpass signal. Thus, the external bandpass signal may comprise an instability of the carrier oscillator which may be eliminated in the baseband signal by the demodulator of the home gateway.

An aspect of the invention relates to a method comprising the steps: Generating a carrier signal, generating a sub-carrier signal by means of a sub-carrier oscillator, mixing the carrier signal with the sub-carrier signal to form a mixed signal, detecting a phase error of the mixed signal, using the detected phase error to stabilise the sub-carrier oscillator, and generating a stabilised double sideband signal comprising the carrier signal and the stabilised sidebands, e.g. the mixing products of the sub-carrier signal and the carrier signal. In particular, at least the one of the mixing products selected as predetermined mixing product is filtered. The phase error of this predetermined mixing product is detected. Therefore, the method can comprise a step of filtering the predetermined mixing product, e.g. by means of a band-pass filter.

The method can further comprise steps of using a single component or multiple components as described above.

In an embodiment, the method further comprises the steps: receiving an external bandpass signal and demodulating the external bandpass signal using the sub-carrier signal of the sub-carrier oscillator.

The method can be applied to a radio communication system.

The method can be applied to a home gateway.

An aspect of the invention relates to a computer program product for controlling a radio communication system.

An aspect of the invention relates to a computer program product for controlling a home gateway.

The invention is further described by embodiments shown in the figures. In particular, it is shown by
- Fig. 1: a radio communication system comprising a carrier oscillator and a sub-carrier oscillator;
- Fig. 2: a radio communication system wherein the carrier oscillator is implemented as an optical generator;
- Fig. 3: a radio communication system comprising an electrical carrier oscillator and an electrical sub-carrier oscillator;
- Fig. 4: a bidirectional communication system;
- Fig. 5: the radio communication system of Fig. 2, arranged in a biderectional communication system; and
- Fig. 6: the radio communication system of Fig. 3, arranged in a biderectional communication system.

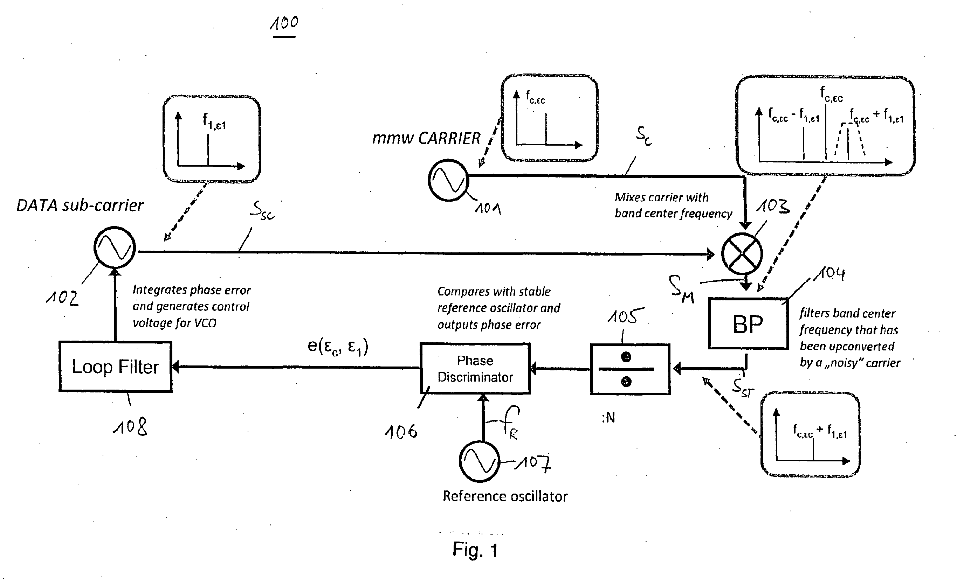

Fig. 1 schematically shows a radio communication system 100, in a simplified way, as an entirely electrical circuit. The radio communication system 100 comprises a carrier oscillator 101 that generates a carrier signal S_{C} and a sub-carrier oscillator 102 that generates a sub-carrier signal S_{SC}. The carrier signal S_{C} is provided at a carrier frequency f_{C} and can be enhanced by a carrier phase error ε_{C}. The sub-carrier signal S_{SC} is provided at a sub-carrier frequency f₁ which is considerably lower than the carrier frequency f_{C}. The sub-carrier signal S_{SC} can be enhanced by a sub-carrier phase error ε₁.

The carrier signal S_{C} and the sub-carrier signal S_{SC} are mixed at mixing means 103. The mixing means 103 can, for example, be a multiplier that generates a mixed signal S_{M} comprising mixing products of the carrier signal S_{C} and the sub-carrier signal S_{SC}. The mixed signal S_{M} comprises signals at the following frequencies: f_{C},_{εc} - f_{1,ε1}, f_{C,εC}, and f_{C,εC} + f_{1,ε1}. The signals at the two frequencies f_{C,εC} - f_{1,ε1} and at f_{C,εC} + f_{1,ε1} form two sideband signals. In other words, the mixed signal S_{M} comprises the carrier signal S_{C} at the carrier frequency f_{C} enhanced by the phase error ε_{C} and two sideband signals, each sideband signal enhanced by a phase error e(ε_{C},ε₁) which is a function of both the carrier phase error ε_{C} and the sub-carrier phase error ε₁.

The mixed signal S_{M} is then led to a first band pass filter 104 that filters one sideband out of the mixed signal S_{M} to form a single-tone signal. In most radio systems comprising a radio communication system used as a transmitter and a receiver, only one sideband is used for fine tuning both the transmitter and the receiver. Even if both sidebands are transmitted together with the carrier signal S_{c}, usually only one of the two sidebands is selected for the transmission and the reception of the information signal. This selected sideband is a predetermined or selected mixing product which is chosen from the multiple mixing products of the mixed signal S_{M} for the stabilising procedure and the transmission of the information.

The first band pass filter 104 centres around a frequency that equals to the centre frequency of one of the two sidebands. In one embodiment, the upper sideband at the frequency f_{c,εc} + f_{1,ε1} is filtered from the mixed signal S_{M} to form a single tone signal S_{ST}. In an alternative embodiment, the band pass filter 104 is configured to filter the lower sideband at f_{C,εc} - f_{1,ε1}.

The single tone signal S_{ST} is fed into a divider 105. The divider 105 comprises a divider component to scale down the frequency of the single tone signal S_{ST} to a manageable frequency. The phase of the signal is then compared at a phase discriminator 106 to the phase of a stable reference oscillator 107. The reference oscillator 107 can, for example, be implemented as a crystal oscillator oscillating at a reference frequency f_{R}. The phase discriminator 106 outputs the phase error e(ε_{C},ε₁) of the single tone signal S_{ST}.

The phase error e(ε_{C},ε₁) of the single tone signal S_{ST} corresponds to a frequency error of its frequency, its deviation from the nominal frequency value. The frequency error of the provided carrier frequency f_{C} from its intended frequency can, for example, be caused by noise and/or by a structurally faulty component of the carrier oscillator and/or by interference/resonance.

The phase error e(ε_{C,}ε₁) is converted into an error voltage signal V_{ε} as an error indicator by a loop filter 108. The loop filter 108 integrates the phase error e(ε_{C},ε₁) and generates a control voltage for the sub-carrier oscillator 102 that comprises the error voltage V_{ε}.

The components described above can be connected electrically, e.g. by wires, to enable a transmission of the different signals between the components.

In the embodiment shown in Fig. 1, a stabilisation of the mixed signal S_{M} is accomplished for two sinusoidal local oscillator signals delivered by the carrier oscillator 101 and the sub-carrier oscillator 102. The sub-carrier oscillator is a voltage controlled oscillator (VCO). The carrier oscillator 101 can be a free running oscillator that cannot be influenced in its phase, e.g. its control voltage cannot influence the carrier frequency f_{C}. The output signal of the carrier oscillator 101 can comprise increased phase noise.

The sub-carrier oscillator 102 is controlled by the phase locked loop that comprises the phase discriminator 106, the reference oscillator 107, and the loop filter 108. The mixed signal S_{M} of both oscillators 101 and 102 is filtered at the sum frequency f_{C,εC} + f_{1,ε1}, the upper sideband signal, and stabilised at a nominal value by controlling the sub-carrier frequency f₁. Thus, this upper sideband signal is chosen as predetermined mixing product from the multiple mixing products of the mixing signal S_{M}.

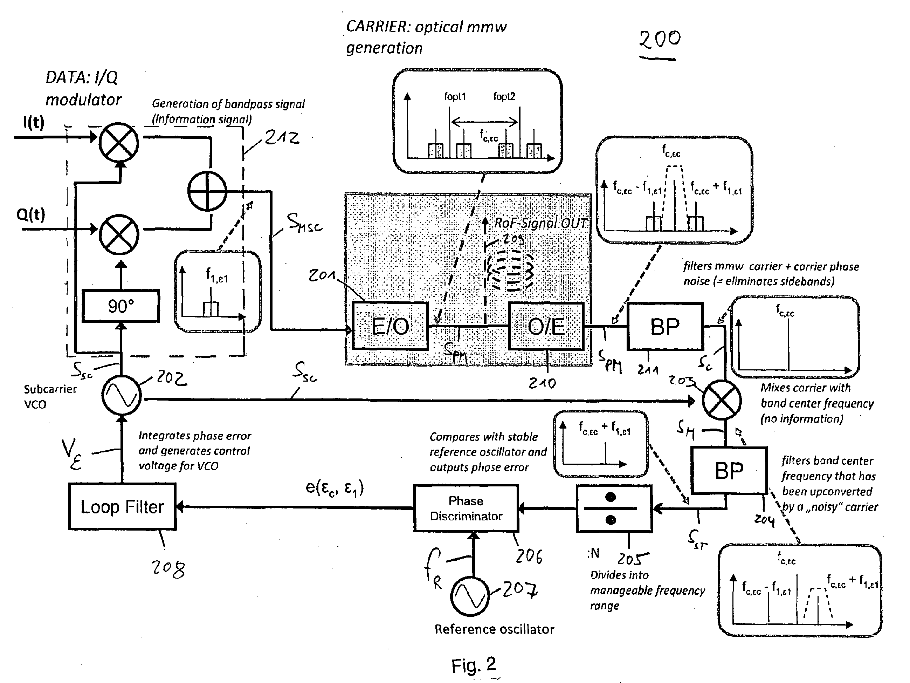

Fig. 2 shows a radio communication system 200 that operates in parts similar to the radio communication system 100 shown in Fig. 1. The radio communication system 200 comprises a sub-carrier oscillator 202 delivering a sub-carrier signal S_{SC} at the sub-carrier frequency f₁.

A complex base band information signal can be described by its time-dependent in-phase and quadrature component. A modulator 212 modulates such an in-phase I(t) and such a quadrature phase Q(t) to the signal of the sub-carrier S_{SC} to form a modulated sub-carrier signal S_{MSC}. The modulated sub-carrier signal S_{MSC} comprises a bandwidth around the sub-carrier frequency f₁ and can carry complex base band information, thereby forming an information signal. The modulated sub-carrier signal S_{MSC} forms a band pass signal. The modulator 212 comprises a 90° phase shifter, a multiplier for mixing the in-phase I(t) to a part of the sub-carrier signal S_{SC}, another multiplier for mixing the quadrature phase Q(t) to a part of the sub-carrier signal S_{SC} shifted by 90° by the phase shifter, and an adder that adds both modulated parts of the sub-carrier signal S_{SC} resulting in the modulated sub-carrier signal S_{MSC}.

The modulated sub-carrier signal S_{MSC} is fed into an electro-optical converter 201. The electro-optical converter 201 is modulated by the modulated sub-carrier signal S_{MSC}. At the conversion process from an electrical signal to an optical signal an optical up-conversion, e.g. mixing, into the millimetre wave range happens. The carrier frequency f_{C} including a carrier phase error ε_{C} is chosen to be in the millimetre wave range. Thus, a pre-mixed signal S_{PM} is generated. The pre-mixed signal S_{PM} can be transmitted over a fibre link carried by the optical wave. The signal is received by an opto-electrical converter 210 which converts the optical signal back into an electrical signal. The electrical signal still contains the pre-mixed signal S_{PM} comprising the carrier frequency f_{C,εC} and the two sidebands f_{C,εC} - f_{1,ε1} and f_{C,εC} + f_{1,ε1}, enhanced with a phase error e(ε_{C},ε₁) of both the carrier oscillator 201 and the sub-carrier oscillator 202 and the bandwidth added from the modulator 212 carrying the information.

The pre-mixed signal S_{PM} passes a second band pass filter 211 that filters only the signal component at the carrier frequency f_{C,εc} enhanced by the carrier phase error ε_{C} out of the pre-mixed signal S_{PM}. The second band pass filter 211 thus generates the carrier signal S_{C} without the mixing products of the carrier signal S_{C} and the modulated sub-carrier signal S_{SC} present in the pre-mixed signal S_{PM}. Further components of the radio communication system 200 work similarly to the components of the radio communication system 100 shown in Fig. 1.

In particular, the radio communication system 200 further comprises mixing means 203 to mix the carrier signal S_{C} with the sub-carrier signal S_{SC} in order to generate the mixed signal S_{M}, a first band pass filter 204 for generating the single tone signal S_{ST}, a divider 205, a phase discriminator 206, a reference oscillator 207, and a loop filter 208 that generates the error voltage V_{ε}, to stabilise the sub-carrier oscillator 202.

The signal component at the carrier oscillator frequency f_{C,εC} is thus electrically filtered from an optically pre-mixed signal S_{PM}, and the phase error e(ε_{C,}ε₁) of the single tone signal S_{ST} is detected by the phase error detection means to control the voltage controlled sub-carrier oscillator 202. The pre-mixed signal S_{PM} is not used to detect the phase error, because a single tone signal can not directly be extracted from its spectrum, as it exhibits a certain band-width depending on the information it is carrying. Therefore, the total phase error of the spectral component at a centre frequency f_{C,εC} + f_{1,ε1} or f_{C,εC} - f_{1,ε1} in the spectrum of the mixed signal S_{M} is detected. By controlling the sub-carrier frequency f₁ through the feedback of the detected phase error e(ε_{C,}ε₁), and using the carrier signal S_{C} to generate the pre-mixed signal S_{PM}, the sideband in the spectrum of S_{PM} can always be placed at the correct frequency despite the inherent instability of the carrier signal S_{C}. A mixing process does not substantially change the phase noise characteristics of the signals to be mixed. Therefore, the instability of the carrier oscillator is transferred to another frequency range.

The pre-mixed signal S_{PM} can be transmitted by a transmitter such that it comprises a stabilised sideband. It is the pre-mixed signal S_{PM} that is supposed to be sent across a transmission channel. The filtering of the pre-mixed signal S_{PM}, and mixing the filtered carrier signal S_{C} anew with the sub-carrier signal S_{SC}, effectively removes its bandwidth. Thus, the phase error e(ε_{C},ε₁) can be detected in the mixed signal S_{M} comprising only single-tone spectral components.

The radio communication system 200 further comprises a transmitter 209 that transmits the optical pre-mixed signal S_{PM} that was generated by the electro-optical converter 201. Alternatively, the radio communication system 200 can also transmit the pre-mixed signal S_{PM} in electrical form after it was converted back into an electrical signal by the opto-electrical converter 210.

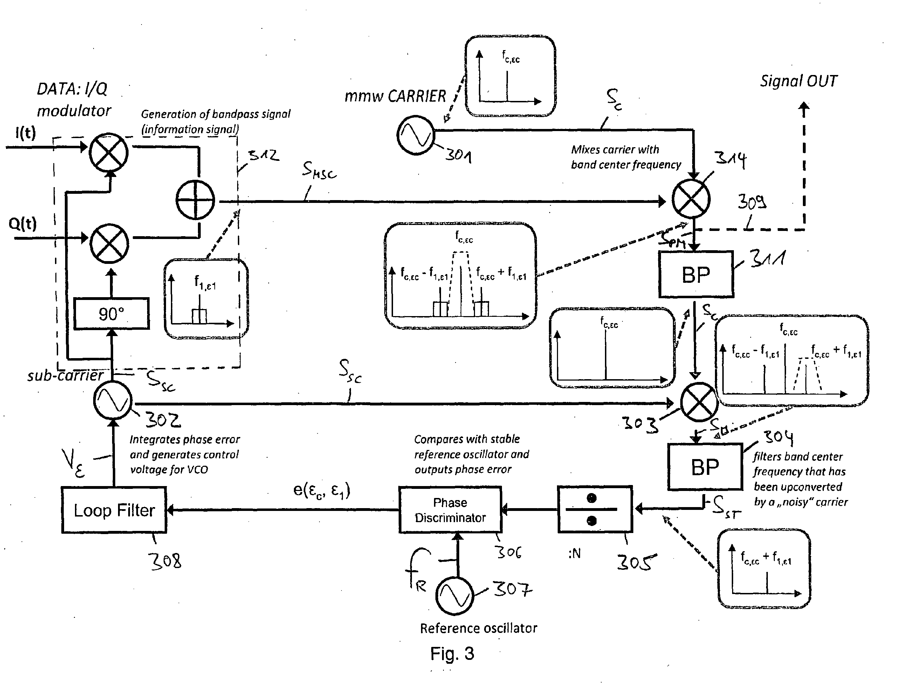

Fig. 3 shows a radio communication system 300 which is built similarly to the radio communication system 200 shown in Fig. 2. In contrast with the radio communication system 200 shown in Fig. 2, the radio communication system 300 shown in Fig. 3 comprises an all electrical circuit.

The radio communication system 300 comprises a sub-carrier oscillator 302 that generates a sub-carrier signal S_{SC} at a sub-carrier frequency f₁. The sub-carrier signal S_{SC} is modulated by a modulator 312 adding information and generating a modulated sub-carrier signal S_{MSC}. The modulated sub-carrier signal S_{MSC} is mixed with the carrier signal S_{C} provided by a carrier oscillator 301 at mixing means 314 to generate a pre-mixed signal S_{PM}. The pre-mixed signal S_{PM} is filtered by a second band pass filter 311 so that only the carrier signal S_{C} comprising the phase error ε remains. Mixing means 303 mixes the extracted carrier signal S_{C} with the sub-carrier signal S_{SC} to form a mixed signal S_{M}.

The mixed signal S_{M} is filtered by a first band pass filter 304 filtering only a single side band to generate the single tone signal S_{ST}. A divider 305, a reference oscillator 307, a phase discriminator 306 and the loop filter 308 form phase error detection means that detects the phase error ε and generates the phase error voltage V_{ε} that stabilises the sub-carrier oscillator 302.

The radio communication system 300 comprises a transmitter 309 that outputs the pre-mixed signal S_{PM} containing the carrier signal S_{C} at the carrier frequency f_{C} and two sidebands carrying information that was modulated to the stabilised sub-carrier signal S_{SC} by the modulator 312. Thus, the transmitter 309 transmits a signal comprising a stabilised sideband.

In the embodiments shown in Figs. 1 to 3, the phase error detection means are provided by the reference oscillators 107, 207, and 307, the phase discriminators 106, 206, and 306, and the loop filters 108, 208, and 308. The sub-carrier oscillators 202 and 302 comprise two outputs to provide the sub-carrier signal S_{SC} to the modulators 212 and 312 and to the mixing means 203 and 303. Alternatively, the sub-carrier oscillators 202 and 302 can comprise one output and means to divide the sub-carrier signal S_{SC} afterwards.

The two sidebands at the frequency f_{C,εC}- f_{1,ε1} and f_{C,εC} + f_{1,ε1} are provided as symmetrical sidebands corresponding to the amplitude modulation (AM), or where applicable, intensity modulation (IM) at the modulation frequency f₁. Mixing the sub-carrier signal S_{SC} with the carrier signal S_{C} that was extracted by the second band pass filter recreates the spectrum at the sidebands without the bandwidth resulting from the modulator. The single tone signal S_{ST} corresponds to the sub-carrier signal, up-converted to the millimetre wave range and enhanced by the phase error of both the carrier frequency f_{C} and the sub-carrier frequency f₁. The phase error of the single tone signal S_{ST} is compensated for by a phase locked loop as phase error detection means.

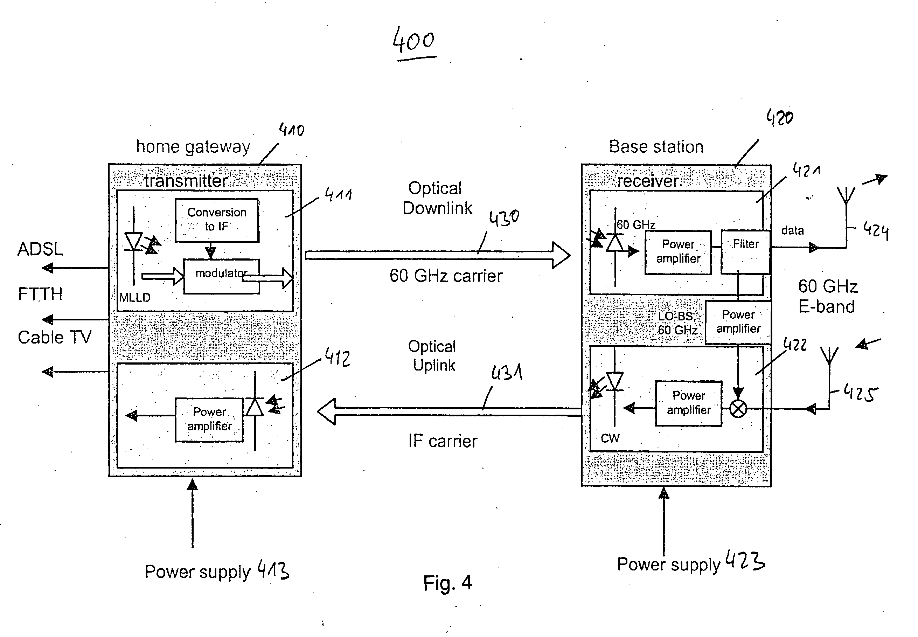

In the embodiments shown in the figures, the radio communication systems 100, 200 and 300 are implemented as a generator of a stabilised sideband signal that can comprise a transmitter for transmitting a stabilised sideband signal. The radio communication system can further comprise a receiver (shown in the figures 4 to 6) to receive the stabilised sideband signal.

The embodiments shown in figures 1 to 3 show the radio communication system and its components and also illustrate the method of how to control and drive this radio communication system to provide a stabilised sideband signal.

The invention enables the stabilisation of a predetermined mixing product centred at the sum and/or difference frequency of two oscillators, wherein only one of the two oscillators needs to be controllable. In particular, the invention enables the stabilisation of an optically generated sideband in the millimetre wave range, independently from the type of optical radio frequency generation (different laser architecture, or laser and modulator). In case of electro-optical converters whose architecture does not allow control of the frequency generating oscillator, the invention enables the stabilisation required for the error-free operation of the radio communication system. In particular, the invention enables the use of low cost, easy to integrate laser architectures, such as the mode locked semiconductor laser for millimetre wave generation described in the following example.

One example of a laser architecture as a carrier oscillator is a passively mode-locked semiconductor laser without saturable absorber section. It exhibits a broad comb spectrum with inherent phase-lock of all optical modes under DC supply conditions only. The physical dimension of the laser cavity determines the different frequencies of the modes and, thus, the beat frequencies of the incident light on a photo-detector. The photo-detector is limited in bandwidth and acts like a low-pass. Thus, the photo-detector filters only the interference corresponding to the lowest frequency. This corresponds to the superposition of the interferences produced by each pair of neighbouring modes. Thus, the phase noise of the superposed modes determines the phase noise of the electrical RF carrier signal Sc. As the laser is operated under DC supply only, the spectral purity of the optical modes cannot be influenced by a conventional control loop. However, it can be used, for example, as carrier oscillator 201 of the radio communication system 200 shown in Fig. 2.

Fig. 4 shows a bidirectional communication system 400. The bidirectioinal communication system comprises a home gateway 410 and a base station 420 arranged to communicate with each other. A data transfer from the home gateway 410 to the base station 420 or a user (not shown in Fig. 4) is done via a downlink 430. A data transfer from the base station 420 or a user to the base station 410 is done via an uplink 431.

The home gateway 410 comprises a transmitter 411 similar to the radio communication system described above with a mode locked laser diode MLLD as carrier oscillator. Instead of the MLLD, the home gateway 410 can comprise any setup performing the same function as the MLLD, e.g., a combination of a laser and a modulator. The home gateway 410 further comprises a demodulator 412 to receive data via the uplink 431 and to demodulate this received data. The home gateway 410 can, e.g., be connected to an asymmetric digital subscriber line ADSL, a fibre to the home FTTH, and/or to cable TV. A power supply 413 is provided to power the home gateway 410.

The base station 420 comprises a receiver 421 arranged to receive data from the optical downlink 430. Furthermore, the base station 420 comprises a transmitter 422 to send data via the optical uplink 431. A power supply 423 powers the base station 420. Further connection devices 424, 425, e.g. implemented as antennas, may be connected to the base station 420 for further data transfer to and from the base station 420.

Preferably, the bidirectional communication station 400 is adapted to transfer data through the downlink 430 in an optical signal comprising a carrier signal in the mmw-range, e.g. with a 60 GHz carrier. Thus, the signal to be transported is already in the desired frequency range so that the base station 420 can forward it via the connection device 424. The base station comprises a first filter for filtering a predetermined sideband signal from the data received via the downlink 430. Therein, the first filter of the base station is arranged immediately, meaning without electrical elements arranged in between, before the antenna connection device 424. The optical downlink 430 connection may comprise a fibre to transfer the data.

The optical uplink 431 connection may also comprise a fiber for the data transfer. Furthermore, the optical uplink 431 may happen at lower frequencies, e.g. without the need of a millimetre wave carrier oscillator and a millimetre carrier frequency. Thus, a less expensive laser can be used in the base station 420 to transfer the data via the uplink 431, and not an expensive mmw-laser.

At present, lasers can not be modulated directly with mmw-signals. This is due to the material dynamics used for state of the art laser devices. In order to generate a mmw-signal, e.g. combinations of lasers and external modulators or special laser diodes as mode-locked laser diodes are used to generate mmw-signals. The latter are not yet available commercially. In the event where combinations of lasers and external modulators have to be employed, the costs rise because of the increased complexity when using several devices.

Within the base station 420, the received signal is converted or mixed down to an intermediate frequency IF. In this IF range, commercial laser diodes, e.g. DFB and VCSEL, can be modulated directly and are available in large quantities which in turn translates into lower system costs. 'Mixing down' and 'converting down' relates to a transformation to a lower frequency range. To accomplish this down conversion, the base station 420 comprises a local oscillator LO_{BS}. The signal of the local oscillator LO_{BS} can be gained from signals received through the downlink 430 by use of a second filter of the base station. The second filter of the base station extracts the carrier signal from the signal received via the downlink 430 and transmits the carrier signal to means for mixing down an external signal for the uplink 431 as signal of the local oscillator LO_{BS}. Thus, the number of hardware-components of the base station 420 is minimized.

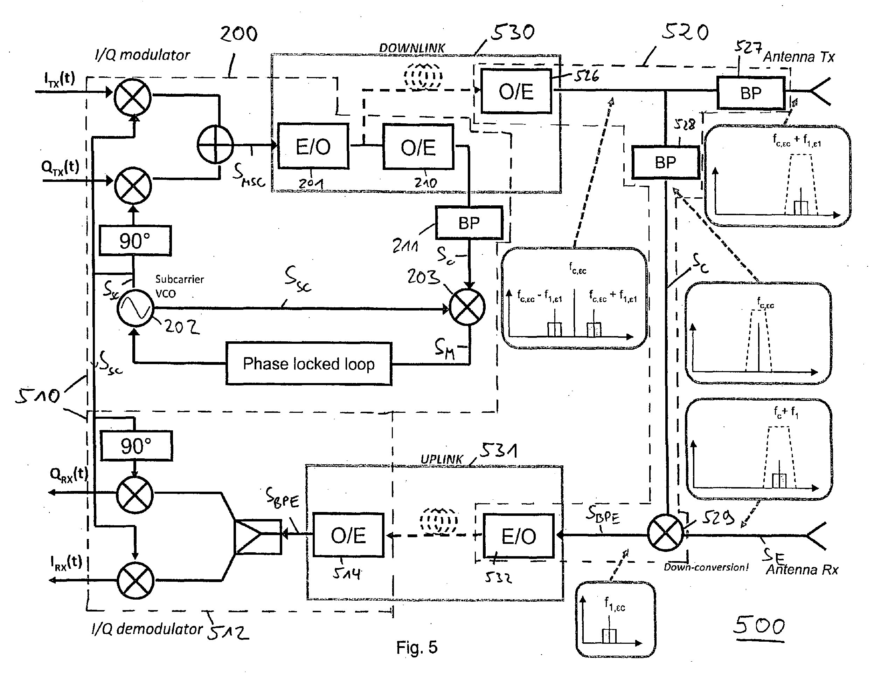

Fig. 5 shows a bidirectional communication system 500. The bidirectional communication system 500 comprises the radio communication system 200 shown in Fig. 2. The radio communication system 200 provides a signal for a downlink 530 to a base station 520. A fiber can be arranged to transfer the pre-mixed signal S_{PM} provided by the radio communication system 200 via the downlink 530 to the base station 520.

The pre-mixed signal S_{PM} is received by an opto-electrical converter 526 of the base station 520. The pre-mixed signal S_{PM} is in the mmw-range and comprises signals at the carrier frequency f_{C,εC} and at the two sideband frequencies f_{C,εC}- f_{1,ε1} and f_{C,εC} + f_{1,ε1} enhanced with a phase error e(ε_{C},ε₁) of both the carrier oscillator 201 and the sub-carrier oscillator 202 and the bandwidth added from the modulator 212 carrying the information. At least one predetermined sideband of the pre-mixed signal S_{PM} is stabilised as described in the description of Fig. 2.

The recieved pre-mixed signal S_{PM} is divided and transferred to both a first bandpass filter 527 and to a second bandpass filter 528 of the base station 520. The first bandpass filter 527 of the base station 520 filters one sideband signal out of the premixed signal S_{PM} which is centered at the frequency f_{C}+f₁. This filtered sideband signal is the predetermined mixing product stabilised by the radio communication system 200 and is transmitted by an antenna Tx.

The second bandbass filter 528 of the base station 520 is arranged to filter the carrier signal S_{C} from the pre-mixed signal S_{PM}. This carrier signal S_{C} is not stabilised, since the stabilisation of the phase locked loop of the radio communication system 200 is stabilising one or more of the mixing products, but not the carrier signal S_{C} itself. This filtered carrier signal S_{C} is used as local oscillator signal LO_{BS} of the base station 520.

Via an antenna Rx an external sideband signal S_{E} can be transmitted to the base station 520. The external sideband signal S_{E} comprises a sideband signal centred at a frequency f_{C} + f₁ that is stabilised externally, wherein this centre frequency comprises the same carrier frequency f_{C} and the same sub-carrier frequency f₁ as used by the radio communication system 200. In particular, this external sideband signal S_{E}, the sideband signal transmitted to the antenna Tx, and the predetermined sideband signal chosen for stabilisation by the phase locked loop of the radio communication system 200 are all at the same frequency, either the sum or the difference of the carrier frequency f_{C} and the sub-carrier frequency f₁.

Together with the local oscillator signal LO_{BS} of the base station 520, the external sideband signal S_{E} is send to a conversion circuit 529 adapted to convert the external sideband signal S_{E} down to its sub-carrier frequency range. The conversion circuit 529 performs the function of a down-converter, whereat the carrier signal S_{C} provided by the second bandpass filter 528 is used as a local oscillator in the mixing process. The external sideband signal S_{E} is thus down-converted and results in the external bandpass signal S_{BFE} in the intermediate frequency range. The resulting external bandpass signal S_{BPE} is at a frequency f_{1,εc}, enhanced by the phase error ε_{C} of the carrier oscillator 201 that is inherent in the carrier signal S_{C} provided by the second band pass filter 528 of the base station 520. Thus, the conversion circuit 529 converts the external signal S_{E} into a signal at the intermediate frequency (IF) f_{1,εc,} meaning at the sub-carrier frequency f₁ carrying the instability of the carrier signal S_{C}.

The external bandpass signal S_{BPE} is used to modulate an electro-optical converter 532 like a laser which provides the signal for an uplink 531. The uplink 531 may be realised as an optical fibre.

Thus, via the uplink 531, the external bandpass signal S_{BPE} centred at the intermediate frequency f_{1,εc} is transmitted to a demodulator 512.

The demodulator 512 is part of the home gateway 510 comprising the radio communication system 200 and the demodulator 512.

The demodulator 512 is adapted to receive the external bandpass signal S_{BPE} at the intermediate frequency f_{1,εc} from the uplink 531 by means of a opto-electrical converter 514. The demodulator 512 is further adapted to demodulate the external bandpass signal S_{BPE}. Thus, the information in form of the corresponding I_{RX} and Q_{RX} symbols is retrieved by the demodulator 512 performing the inverse operation of modulator 212 and 312. Since the external bandpass signal S_{BPE} was generated using the non-stabilised local oscillator signal LO_{BS} of the base station 530, the instability of the carrier oscillator 201 is also found in the received baseband signal.

The sub-carrier oscillator 202 of the radio communication system 200 is arranged to deliver its sub-carrier signal S_{C} to at least three different circuit-parts of the bidirectional communication system: As described in connection with Fig. 2, the sub-carrier signal S_{SC} is sent to the modulator 212 to generate the information carrying and modulated sub-carrier signal S_{MSC}. The sub-carrier signal S_{SC} is also sent to the mixing means 203 to generate the mixed signal S_{M}. Furthermore, the sub-carrier signal S_{SC} is transmitted to the demodulator 512 and used by its demodulation circuit to demodulate the quadrature phase Q_{RX}(t) and the inphase I_{RX}(t) from the external bandpass signal S_{BPE} and, thus, forming the baseband signal.

By using the subcarrier signal S_{SC} generated by the radio communication 200 implemented as stabilising unit to demodulate the external bandpass signal S_{BPE}, the instability resulting from the carrier signal S_{C} is compensated for in the baseband signal generated by the demodulator 512.

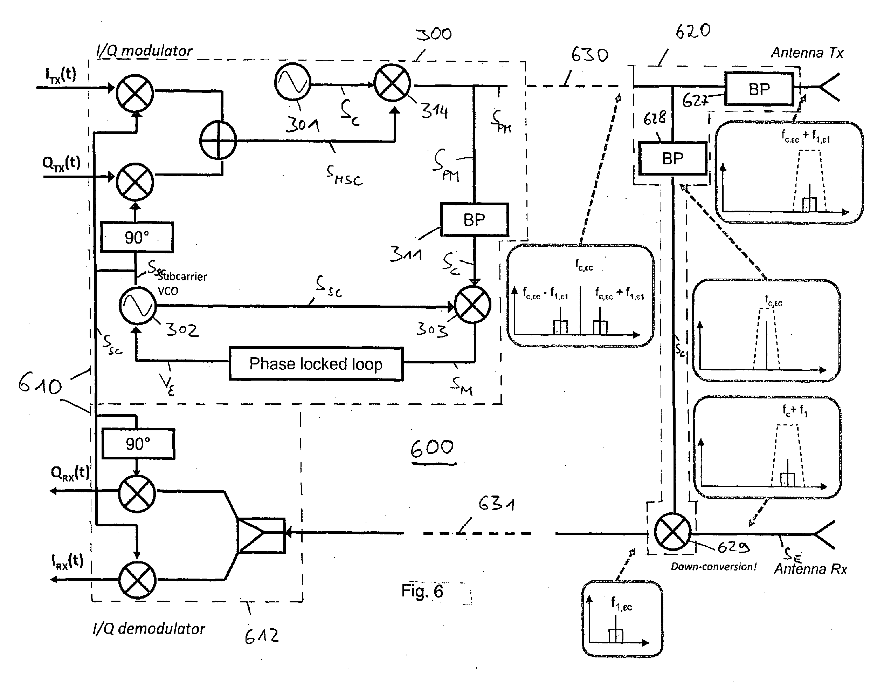

Fig. 6 shows a bidirectional communication system 600 comprising a base station 620 and a home gateway 610. The home gateway 610 comprises the radio communication system 300 shown in Fig. 3 and a demodulator 612.

The birectional communication system 600 is built similarly to the birectional communication system 500 shown in Fig. 5. In contrast with the bidirectional communication system 500 shown in Fig. 5, the bidirectional communication system 600 shown in Fig. 6 comprises an all electrical circuit.

The pre-mixed signal S_{PM} is generated at the mixing means 314 and sent via a downlink 630 to the base station 620. Via a first bandpass 627 of the base station 620, the predetermined sideband signal is filtered from the pre-mixed signal S_{PM} and transmitted via antenna Tx out of the bidirectional communication system 600.

A second bandpass filter 628 of the base station 620 is filtering the carrier signal S_{C} from the pre-mixed signal S_{PM}. This carrier signal S_{C} forms a local oscillator signal LO_{BS} of the bases station 620 and is used by converter means 629 to convert the external signal S_{E} down into the external bandpass signal S_{BPE}.

The external bandpass signal S_{BPE} is sent via an uplink 631 to the demodulator 610. The demodulator 610 is arranged to receive the sub-carrier signal S_{C} from the radio communication system 300. The demodulator 610 uses the sub-carrier signal S_{C} to demodulate the external bandpass signal S_{BPE} in order to retrieve the baseband signal. By using the sub-carrier signal S_{C} which is modified by the stabilising function of the radio communication system 300, the resulting baseband signal is stabilised.

The bidirectional communication systems 400, 500, and 600 need only one expensive carrier oscillator 101, 201, 301 with millimetre wave capabilities to generate the carrier signal S_{C}, e.g. in the mmw-range. The base station 420, 520, and 620 need no carrier oscillator, since the carrier signal S_{C} of the radio communication system 100, 200, 300 is used to convert the external signal S_{E} down to the external bandpass signal S_{BPE}. An instability inherent in this carrier signal S_{C} resulting from the missing stabilisation of the carrier oscillator 101, 201, 301 itself is compensated for by the demodulator 412, 512, 612 by using the sub-carrier signal S_{SC} of the stabilised sub-carrier oscillator 102, 202, 302 to demodulate the external bandpass signal S_{BPE}.

As an example, the radio communication systems described above can operate in the band from 57-66 GHz where an over-all bandwidth of 9 GHz is available for license-free communication in Europe, Europe being the region that restricts the least. Therefore, in this particular example for European communication systems and under the actual license conditions (in the year 2011), the transmission sideband mustremain within this band for license-free communication in Europe. Therefore, for a carrier frequency f_{C} of about 60 GHz, the sub-carrier frequency can, e.g., be allocated between 1 and 6 GHz, in particular between 1 and 3 GHz, Depending on the radio standard, different channels that can be occupied by the transmission sideband can be used. Examples for the allocated channels can be found in:
- IEEE 802.15c-2009: MAC and PHY Specification for High Rate Wireless Personal Area Networks, page 60
- ECMA-387: High Rate 60GHz PHY, MAC and HDMI PAL, page 96

The standards denote the centre frequencies of the bands (f_{C} + f₁ or f_{C} - f₁) used for transmission. The carrier frequencies should be chosen according to the designated band centre frequency and the chosen bandwidth. For example, IEEE 802.15c or ECMA 387 channel 1 has a bandwidth of 2.61 GHz with a centre frequency of 58.320 GHz, the outer band limits being 57.240 GHz and 59.400 GHz. Once the channel has been chosen, the respective standard transmit mask has to be respected, thus providing a (lower) limit for the sub-carrier frequency with respect to the chosen carrier. Spectral masks can be found in the standards:
- IEEE 802.15c-2009: MAC and PHY Specification for High Rate Wireless Personal Area Networks, page 60 - 61
- ECMA-387: High Rate 60GHz PHY, MAC and HDMI PAL, page 98-99

### List of Reference Numerals

- 100: radio communication system
- 101: carrier oscillator
- 102: sub-carrier oscillator
- 103: mixing means
- 104: first band pass filter
- 105: divider
- 106: phase discriminator
- 107: reference oscillator
- 108: phase locked loop
- 200: radio communication system
- 201: carrier oscillator
- 202: sub-carrier oscillator
- 203: mixing means
- 204: first band pass filter
- 205: divider
- 206: phase discriminator
- 207: reference oscillator
- 208: phase locked loop
- 209: transmitter
- 210: opto-electrical converter
- 211: second band pass filter
- 212: modulator
- 300: radio communication system
- 301: carrier oscillator
- 302: sub-carrier oscillator
- 303: mixing means
- 304: first band pass filter
- 305: divider
- 306: phase discriminator
- 307: reference oscillator
- 308: phase locked loop
- 309: transmitter
- 311: second band pass filter
- 312: modulator
- 314: pre-mixing means
- 400: bidirectional communication system
- 410: home gateway
- 411: transmitter
- 412: demodulator
- 413: power supply
- 420: base station
- 421: receiver
- 422: transmitter
- 423: power supply
- 430: downlink
- 431: uplink
- 424: connection
- 425: connection
- 500: bidirectional communication system
- 510: home gateway
- 512: demodulator
- 514: opto-electrical converter
- 520: base station
- 526: opto-electrical converter
- 527: first bandpass filter of the base station
- 528: second bandpass filter of the base station
- 529: conversion circuit
- 530: downlink
- 531: uplink
- 532: electric-optical converter
- 600: bidirectional communication system
- 610: home gateway
- 612: demodulator
- 620: base station
- 627: first bandpass filter of the base station
- 628: second bandpass filter of the base station
- 629: conversion means
- 630: downlink
- 631: uplink
- f₁: sub-carrier frequency
- f_{C}: carrier frequency
- f_{R}: reference frequency
- ε_{C}: carrier phase error
- ε1: sub-carrier phase error
- e(ε_{C}, ε1): phase error
- Tx: external sending antenna
- Rx: external receiving antenna
- V_{ε}: error voltage
- S_{BPE}: external bandpass signal
- S_{C}: carrier signal
- S_{SC}: sub-carrier signal
- S_{E}: external sideband signal
- S_{MSC}: modulated sub-carrier signal
- S_{M}: mixed signal
- S_{PM}: pre-mixed signal
- S_{ST}: single-tone signal

## Claims

1. Radio communication system for transmitting information in a stabilized sideband signal comprising
- a carrier oscillator (101; 201; 301) configured to generate a carrier signal (S_{C}) at a carrier frequency (fc),
- a sub-carrier oscillator (102; 202; 302) configured to generate a sub-carrier signal (S_{SC}) at a sub-carrier frequency (f₁),
- a modulator (212; 312) arranged to modulate an information signal to the sub-carrier signal (S_{SC}), thereby generating a modulated sub-carried signal (S_{MSC})
- a pre-mixing means (201; 314) configured to generate a pre-mixed signal (S_{PM}) comprising the carrier signal (S_{C}), the modulated sub-carrier signal (S_{MSC}), and mixing products of the carrier signal (S_{C}) and the modulated sub-carrier signal. (S_{MSC}), one of the mixing products being the stabilized sideband for transmitting information,
- a second band pass filter (211; 311) arranged to extract the carrier signal (S_{C}) out of the pre-mixed signal (S_{PM}),
- a mixing means (103; 203; 303) configured to generate a mixed signal (S_{M}) enhanced by a phase error (e(ε_{C},ε₁)), the mixed signal (S_{M}) comprising the carrier signal (S_{C}) extracted out of the pre-mixed signal (S_{PM}), the phase error (e(ε_{C},ε₁)) and mixing products of the modulated sub-carrier signal (S_{MSC}) and the extracted carrier signal (S_{C}),
- a phase error detection means (106, 107, 108; 206, 207, 208; 306, 307, 308) configured to generate an error-indicator (V_{ε}) corresponding to and based on the phase error (e(ε_{C},ε₁))of the mixed signal (S_{M}) comprising mixing products of the extracted carrier signal (S_{C}) and the sub-carrier signal (S_{SC}), wherein
the sub-carrier oscillator (102; 202; 302) is implemented as a controlled-oscillator (102; 202; 302) being controlled by the error-indicator (V_{ε}) of the phase error detection means (106, 107, 108; 206, 207, 208; 306, 307, 308).

2. System according to claim 1, wherein the sub-carrier oscillator (102; 202; 302) is stabilised by the phase error detection means (106, 107, 108; 206, 207, 208; 306, 307, 308).

3. System according to any of the preceding claims, wherein the phase error detection means (106, 107, 108; 206, 207, 208; 306, 307, 308) is implemented as and/or comprises a phase locked loop (108; 208; 308).

4. System according to any of the preceding claims, comprising a transmitter (201; 309) to transmit a modulated sideband-signal comprising the sub-carrier signal (S_{SC}) controlled by the error-indicator (V_{ε}) of the phase error detection means (106, 107, 108; 206, 207, 208; 306, 307, 308).

5. System according to any of the preceding claims, wherein the carrier oscillator (101; 201; 301) is implemented as an optical oscillator (201), and/or an mmw-oscillator, and/or as a free-running oscillator comprising a fixed control voltage or fixed drive current, wherein the carrier oscillator may be implemented as a laser.

6. System according to any of the preceding claims, comprising a first band pass filter (104; 204; 304) arranged to filter a predetermined mixing product from the spectrum of the mixed signal (S_{M}) comprising the carrier signal (S_{C}) and the mixing products of the carrier and the sub-carrier signals.

7. System according to any of the preceding claims, comprising a reference oscillator (107; 207; 307) arranged to provide a reference frequency (f_{R}) to the phase error detection means (106, 107, 108; 206, 207, 208; 306, 307, 308).

8. System according to any of the preceding claims, wherein the sub-carrier oscillator (102; 202; 302) is configured to oscillate at the sub-carrier frequency (f₁), wherein the sub-carrier frequency (f₁) is substantially lower than the carrier frequency (f_{C}) of the carrier oscillator (101; 201; 301).

9. Home gateway comprising a radio communication system according to any of the preceding claims, comprising a demodulator (412; 512; 612) adapted to demodulate an external bandpass signal (S_{BPE}) using the sub-carrier signal (S_{SC}) provided by the sub-carrier oscillator (102; 202; 302) of the radio communication system (100; 200; 300).

10. Bidirectional communication system comprising a home gateway according to claim 9, comprising a base station (420; 520; 620), wherein a downlink (431; 531; 631) is adapted to transmit a signal (S_{PM}) from the radio communication system (100; 200; 300) to the base station (420; 520; 620), and wherein an uplink (431; 531; 631) is adapted to transmit the external bandpass signal (S_{BPE}) from the base station (420; 520; 620) to the demodulator (412; 512; 612).

11. Method for stabilising a sideband-signal for transmitting information, comprising the steps:
- generating a carrier signal (S_{C}),
- generating a sub-carrier signal (S_{SC}) by means of a sub-carrier oscillator (102; 202; 302)
- modulating an information signal to the sub-carrier signal (S_{SC}), thereby generating a modulated sub-carried signal (S_{MSC})
- generating a pre-mixed signal (S_{PM}) comprising the carrier signal (S_{C}), the modulated sub-carrier signal (S_{MSC}), and mixing products of the carrier signal (S_{C}) and the modulated sub-carrier signal (S_{MSC}), one of the mixing products being the stabilized sideband for transmitting information,
- extracting the carrier signal (S_{C}) out of the pre-mixed signal (S_{PM}),
- generating a mixed signal (S_{M}) enhanced by a phase error (e(ε_{C},ε₁)), the mixed signal (S_{M}) comprising the carrier signal (S_{C}) extracted out of the pre-mixed signal (S_{PM}), the phase error (e(ε_{C},ε₁)) and mixing products of the modulated sub-carrier signal (S_{MSC}) and the extracted carrier signal (Sc),
- detecting the phase error (e(ε_{C},ε₁)) of the mixed signal (S_{M}) comprising mixing products of the extracted carrier signal (S_{C}) and the sub-carrier signal (S_{SC}),
- using the detected phase error (e(ε_{C}, ε₁)) to stabilise the sub-carrier oscillator (102; 202; 302) to generate a stabilised sub-carrier signal (S_{SC}), and
- generating a stabilised sideband-signal comprising the carrier signal (S_{C}) and the stabilised sub-carrier signal (S_{SC}).

12. Method according to claim 11, further comprising the steps:
- receiving an external bandpass signal (S_{BPE}) and
- demodulating the external bandpass signal (S_{BPE}) using the sub-carrier signal (Ssc).

## Patentansprüche

1. Funkkommunikationssystem zur Übertragung von Information in einem stabilisierten Seitenbandsignal, das Folgendes umfasst:
- einen Trägeroszillator (101; 201; 301), der dazu konfiguriert ist, ein Trägersignal (Sc) bei einer Trägerfrequenz (fc) zu erzeugen,
- einen Hilfsträger-Oszillator (102; 202; 302), der dazu konfiguriert ist, ein Hilfsträgersignal (Ssc) bei einer Hilfsträgerfrequenz (f₁) zu erzeugen,
- einen Modulator (212; 312), der dazu eingerichtet ist, ein Informationssignal auf das Hilfsträgersignal (Ssc) zu modulieren, wodurch er ein moduliertes Hilfsträgersignal (S_{MSC}) erzeugt,
- ein vorvermischendes Mittel (201; 314), das dazu konfiguriert ist, ein vorvermischtes Signal (S_{PM}) zu erzeugen, das das Trägersignal (Sc), das modulierte Hilfsträgersignal (S_{MSC}) und Mischerzeugnisse aus dem Trägersignal (Sc) und dem modulierten Hilfsträgersignal (S_{MSC}) umfasst, wobei eines der Mischerzeugnisse das stabilisierte Seitenbandsignal zur Übertragung von Information ist,
- einen zweiten Bandpassfilter (211; 311), der dazu eingerichtet ist, das Trägersignal (Sc) aus dem vorvermischten Signal (S_{PM}) zu extrahieren,
- ein vermischendes Mittel (103; 203; 303), das dazu konfiguriert ist, ein Mischsignal (S_{M}) zu erzeugen, das durch einen Phasenfehler (e(ε_{C}, ε₁)) verstärkt wird (*enhanced*), wobei das Mischsignal (S_{M}) das aus dem vorvermischten Signal (S_{PM}) extrahierte Trägersignal (Sc), den Phasenfehler (e(εC, ε₁)) und Mischerzeugnisse aus dem modulierten Hilfsträgersignal (S_{MSC}) und dem extrahierten Trägersignal (Sc) umfasst,
- ein Phasenfehler-Erfassungsmittel (106, 107, 108; 206, 207, 208; 306, 307, 308), das dazu konfiguriert ist, einen Fehlerindikator (V_{ε}) zu erzeugen, der auf dem Phasenfehler (e(ε_{C}, ε₁)) des Mischsignals (S_{M}) basiert und diesem entspricht, Mischerzeugnisse umfassend aus dem extrahierten Trägersignal (Sc) und dem Hilfsträgersignal (Ssc), wobei
der Hilfsträger-Oszillator (102; 202; 302) als gesteuerter Oszillator (102; 202; 302) implementiert ist, wobei er durch den Fehlerindikator (V_{ε}) des Phasenfehler-Erfassungsmittels (106, 107, 108; 206, 207, 208; 306, 307, 308) gesteuert wird.

2. System nach Anspruch 1, wobei der Hilfsträger-Oszillator (102; 202; 302) durch das Phasenfehler-Erfassungsmittel (106, 107, 108; 206, 207, 208; 306, 307, 308) stabilisiert wird.

3. System nach irgendeinem der vorhergehenden Ansprüche, wobei das Phasenfehler-Erfassungsmittel (106, 107, 108; 206, 207, 208; 306, 307, 308) als Phasenregelschleife (108; 208; 308) implementiert wird und/oder diese umfasst.

4. System nach irgendeinem der vorhergehenden Ansprüche, umfassend einen Sender (201; 309), um ein moduliertes Seitenbandsignal zu senden, das das Hilfsträgersignal (Ssc) umfasst, welches durch den Fehlerindikator (V_{ε}) des Phasenfehler-Erfassungsmittels (106, 107, 108; 206, 207, 208; 306, 307, 308) gesteuert wird.

5. System nach irgendeinem der vorhergehenden Ansprüche, wobei der Trägeroszillator (101; 201; 301) als optischer Oszillator (201) und/oder als mmw-Oszillator implementiert wird und/oder als frei schwingender Oszillator, der eine feste Regelungsspannung oder einen festen Ansteuerungsstrom umfasst, wobei der Trägeroszillator als Laser implementiert werden kann.

6. System nach irgendeinem der vorhergehenden Ansprüche, umfassend einen ersten Bandpassfilter (104; 204, 304), der dazu eingerichtet ist ein vorbestimmtes Mischerzeugnis aus dem Spektrum des Mischsignals (S_{M}) zu filtern, das das Trägersignal (Sc) und die Mischerzeugnisse des Träger- und HilfsträgerSignals umfasst.

7. System nach irgendeinem der vorhergehenden Ansprüche, umfassend einen Referenz-Oszillator (107; 207; 307), der dazu eingerichtet ist, eine ReferenzFrequenz (f_{R}) für das Phasenfehler-Erfassungsmittel (106, 107, 108; 206, 207, 208; 306, 307, 308) bereitzustellen.

8. System nach irgendeinem der vorhergehenden Ansprüche, wobei der Hilfsträger-Oszillator (102; 202; 302) dazu konfiguriert ist, bei der Hilfsträgerfrequenz (f₁) zu schwingen, wobei die Hilfsträgerfrequenz (f₁) im Wesentlichen niedriger als die Trägerfrequenz (fc) des Trägeroszillators (101; 201; 301) ist.

9. Heim-Gateway, das ein Funkkommunikationssystem nach irgendeinem der vorhergehenden Ansprüche umfasst, das einen Demodulator (412; 512; 612) umfasst, der dazu angepasst ist, ein externes Bandpass-Signal (S_{BPE}) unter Verwendung des Hilfsträgersignals (Ssc) zu demodulieren, das vom Hilfsträger-Oszillator (102; 202; 302) des Funkkommunikationssystems (100; 200; 300) bereitgestellt wird.

10. Bidirektionales Kommunikationssystem, das ein Heim-Gateway nach Anspruch 9 umfasst, das eine Basis-Station (420; 520; 620) umfasst, wobei ein *Downlink* (431; 531; 631) dazu angepasst ist, ein Signal (S_{PM}) vom Funkkommunikationssystem (100; 200; 300) zur Basis-Station (420; 520; 620) zu übertragen, und wobei ein *Uplink* (431; 531; 631) dazu angepasst ist, das externe Bandpass-Signal (S_{BPE}) von der Basis-Station (420; 520; 620) zum Demodulator (412; 512; 612) zu übertragen.

11. Verfahren zur Stabilisierung eines Seitenbandsignals zur Übertragung von Information, das folgende Schritte umfasst:
- erzeugen eines Trägersignals (Sc),
- erzeugen eines Hilfsträgersignals (Ssc) mittels eines Hilfsträger-Oszillators (102; 202; 302),
- modulieren eines Informationssignals auf das Hilfsträgersignal (Ssc), wodurch er ein moduliertes Hilfsträgersignal (S_{MSC}) erzeugt wird,
- erzeugen eines vorvermischten Signals (S_{PM}), das das Trägersignal (Sc), das modulierte Hilfsträgersignal (S_{MSC}) und Mischerzeugnisse aus dem Trägersignal (Sc) und dem modulierten Hilfsträgersignal (S_{MSC}) umfasst, wobei eines der Mischerzeugnisse das stabilisierte Seitenbandsignal zur Übertragung von Information ist,
- extrahieren des Trägersignals (Sc) aus dem vorvermischten Signal (S_{PM}),
- erzeugen eines Mischsignals (S_{M}), das durch einen Phasenfehler (e(ε_{C}, ε₁)) verstärkt wird (*enhanced*), wobei das Mischsignal (S_{M}) das aus dem vorvermischten Signal (S_{PM}) extrahierte Trägersignal (Sc), den Phasenfehler (e(ε_{C}, ε₁)) und Mischerzeugnisse aus dem modulierten Hilfsträgersignal (S_{MSC}) und dem extrahierten Trägersignal (Sc) umfasst,
- ermitteln eines Phasenfehlers (e(ε_{C}, ε₁)) des Mischsignals (S_{M}), Mischerzeugnisse umfassend aus dem extrahierten Trägersignal (Sc) und dem Hilfsträgersignal (Ssc),
- verwenden des Phasenfehlers (e(ε_{C}, ε₁)), um den Hilfsträger-Oszillator (102; 202; 302) zu stabilisieren zur Erzeugung eines stabilisierten Hilfsträgersignals (Ssc), und
- erzeugen eines stabilisierten Seitenbandsignals, das das Trägersignal (Sc) und das stabilisierte Hilfsträgersignal (Ssc) umfasst.

12. Verfahren nach Anspruch 11, das des Weiteren die folgenden Schritte umfasst:
- empfangen eines externen Bandpass-Signals (S_{BPE}) und
- demodulieren des externen Bandpass-Signals (S_{BPE}) unter Verwendung des Hilfsträgersignals (Ssc).

## Revendications

1. Un système de communication radio pour transmettre de l'information dans un signal stabilisé à bande latérale, comprenant :
- un oscillateur de porteuse (101 ; 201 ; 301) configuré pour générer un signal porteur (Sc) à une fréquence de porteuse (fc),
- un oscillateur de sous-porteuse (102 ; 202 ; 302) configuré pour générer un signal sous-porteur (Ssc) à une fréquence de sous-porteuse (f₁),
- un modulateur (212 ; 312) agencé pour moduler un signal d'information sur le signal sous-porteur (Ssc), en générant ainsi un signal sous-porteur modulé (S_{MSC}),
- un moyen de pré-mixage (201 ; 314) configuré pour générer un signal pré-mixé (S_{PM}), comprenant le signal porteur (Sc), le signal sous-porteur modulé (S_{MSC}) et des produits de mixage du signal porteur (Sc) et du signal sous-porteur modulé (S_{MSC}), un des produits de mixage étant la bande latérale stabilisée pour la transmission d'information,
- un deuxième filtre passe-bande (211 ; 311) agencé pour extraire le signal porteur (Sc) hors du signal pré-mixé (S_{PM}),
- un moyen de mixage (103 ; 203 ; 303) configuré pour générer un signal mixé (S_{M}) renforcé par une erreur de phase (e(ε_{C}, ε₁)), le signal mixé (S_{M}) comprenant le signal porteur (Sc) extrait hors du signal pré-mixé (S_{PM}), l'erreur de phase (e(ε_{C}, ε₁)) et des produits de mixage du signal sous-porteur modulé (S_{MSC}) et du signal porteur (Sc) extrait,
- un moyen de détection d'erreur de phase (106, 107, 108 ; 206, 207, 208 ; 306, 307, 308) configuré pour générer un indicateur d'erreur (V_{ε}) correspondant à et basé sur l'erreur de phase (e(ε_{C}, ε₁)) du signal mixé (S_{M}) comprenant des produits de mixage du signal porteur (Sc) extrait et du signal sous-porteur (Ssc), sachant que
l'oscillateur de sous-porteuse (102 ; 202 ; 302) est mis en oeuvre sous forme d'oscillateur commandé (102 ; 202 ; 302) étant commandé par l'indicateur d'erreur (V_{ε}) du moyen de détection d'erreur de phase (106, 107, 108 ; 206, 207, 208 ; 306, 307, 308).

2. Système d'après la revendication 1, sachant que l'oscillateur de sous-porteuse (102 ; 202 ; 302) est stabilisé par le moyen de détection d'erreur de phase (106, 107, 108 ; 206, 207, 208 ; 306, 307, 308).

3. Système d'après une des revendications précédentes, sachant que le moyen de détection d'erreur de phase (106, 107, 108 ; 206, 207, 208 ; 306, 307, 308) est mis en oeuvre sous forme de et/ou comprend une boucle à verrouillage de phase (108 ; 208 ; 308).

4. Système d'après une des revendications précédentes, comprenant un émetteur (201 ; 309) pour transmettre un signal à bande latérale modulé comprenant le signal sous-porteur (Ssc), commandé par l'indicateur d'erreur (V_{ε}) du moyen de détection d'erreur de phase (106, 107, 108 ; 206, 207, 208 ; 306, 307, 308).

5. Système d'après une des revendications précédentes, sachant que l'oscillateur de porteuse (101 ; 201 ; 301) est mis en oeuvre sous forme d'oscillateur optique (201), et/ou sous forme de oscillateur omm *(mmw*), et/ou sous forme de oscillateur non asservi ou relaxé (*free*-*running*) comprenant une tension de commande fixe ou un courant d'attaque fixe, sachant que l'oscillateur de porteuse peut être mis en oeuvre sous forme de laser.

6. Système d'après une des revendications précédentes, comprenant un premier filtre passe-bande (104 ; 204 ; 304) agencé pour filtrer un produit de mixage prédéterminé à partir du spectre du signal mixé (S_{M}) comprenant le signal porteur (Sc) et le produits de mixage du signaux porteur et sous-porteur.

7. Système d'après une des revendications précédentes, comprenant un oscillateur de référence (107 ; 207 ; 307) agencé pour fournir une fréquence de référence (f_{R}) au moyen de détection d'erreur de phase (106, 107, 108 ; 206, 207, 208 ; 306; 307, 308).

8. Système d'après une des revendications précédentes, sachant que l'oscillateur de sous-porteuse (102 ; 202 ; 302) est configuré pour osciller à la fréquence de sous-porteuse (f₁), sachant que la fréquence de sous-porteuse (f₁) est essentiellement inférieure à la fréquence de porteuse (fc) de l'oscillateur de porteuse (101 ; 201 ; 301).

9. Passerelle domestique comprenant un système de communication radio d'après une des revendications précédentes, comprenant un démodulateur (412 ; 512 ; 612) adapté pour démoduler un signal passe-bande (S_{BPE}) en utilisant le signal sous-porteur (Ssc) fourni par l'oscillateur de sous-porteuse (102 ; 202 ; 302) du système de communication radio (100 ; 200 ; 300).

10. Système de communication bidirectionnel comprenant une passerelle domestique d'après la revendication 9, comprenant une station de base (420 ; 520 ; 620), sachant qu'une liaison descendante (431 ; 531 ; 631) est adaptée pour transmettre un signal (S_{PM}) à partir du système de communication radio (100 ; 200 ; 300) à la station de base (420 ; 520 ; 620), et sachant qu'une liaison ascendante (431 ; 531 ; 631) est adaptée pour transmettre un signal passe-bande (S_{BPE}) à partir de la station de base (420 ; 520 ; 620) au démodulateur (412 ; 512 ; 612).

11. Procédé pour stabiliser un signal passe bande pour transmettre une information, comprenant les étapes consistant à :
- générer un signal porteur (Sc),
- générer un signal sous-porteur (Ssc) au moyen d'un oscillateur de sous-porteuse (102 ; 202 ; 302),
- moduler un signal d'information sur le signal sous-porteur (Ssc), en générant ainsi un signal sous-porteur modulé (S_{MSC}),
- générer un signal pré-mixé (S_{PM}), comprenant le signal porteur (S_{C}), le signal sous-porteur modulé (S_{MSC}) et des produits de mixage du signal porteur (Sc) et du signal sous-porteur modulé (S_{MSC}), un des produits de mixage étant la bande latérale stabilisée pour la transmission d'information,
- extraire le signal porteur (Sc) hors du signal pré-mixé (S_{PM}),
- générer un signal mixé (S_{M}) renforcé par une erreur de phase (e(ε_{C}, ε₁)), le signal mixé (S_{M}) comprenant le signal porteur (Sc) extrait hors du signal pré-mixé (S_{PM}), l'erreur de phase (e(ε_{C}, ε₁)) et des produits de mixage du signal sous-porteur modulé (S_{MSC}) et du signal porteur (Sc) extrait,
- détecter l'erreur de phase (e(ε_{C}, ε₁)) du signal mixé (S_{M}) comprenant des produits de mixage du signal porteur (Sc) extrait et du signal sous-porteur (Ssc),
- utiliser l'erreur de phase (e(ε_{C}, ε₁)) pour stabiliser l'oscillateur de sous-porteuse (102 ; 202 ; 302) pour générer un signal sous-porteur (Ssc) stabilisé, et
- générer un signal stabilisé à bande latérale comprenant le signal porteur (S_{C}) et le signal sous-porteur (Ssc) stabilisé.

12. Procédé d'après la revendication 11, comprenant en outre les étapes consistant à :
- recevoir un signal passe-bande (S_{BPE}) extérieur et
- démoduler le signal passe-bande (S_{BPE}) extérieur en utilisant le signal sous-porteur (Ssc).
